# EUROPEAN PATENT APPLICATION

(11) **EP 2 208 947 A2**
(43) Date of publication of application: **21.07.2010**
(21) Application number: 10150697.0
(22) Date of filing: 13.01.2010
(51) Int. Cl.: F24J 2/06, F24J 2/10, F24J 2/18, F24J 2/52, H01L 31/042

(54) **Three-dimensional solar energy receiving device**

(30) Priority: 14.01.2009 TW 98200610 U
(71) Applicant: Sunyen Co., Ltd., Hsinchu County 302 (TW)
(72) Inventor: TU, Yu-Ta, Jhubei City (TW)
(74) Representative: Chaillot, Geneviève

(57) **Abstract**

The solar energy receiving device is composed of a solar energy collector (2) and a sunbeam guiding unit (3). The solar energy collector is formed by a bottom plate (20) and four side walls (21), all of which are made by solar 5panels. The sunbeam guiding unit is disposed in or over the solar energy collector for reflecting or refracting the sunbeams to the bottom plate and the side walls.

## Description

### Background of the Invention

### 1. Technical Field

The invention generally relates to solar generation, particularly to solar energy collectors.

### 2. Related Art

Price climbing of petroleum forces replacement energy to be developed fast. Green energy under natural environment, such solar energy and wind power, can effectively reduce greenhouse gas emission. Therefore, green energy must be seriously treated.

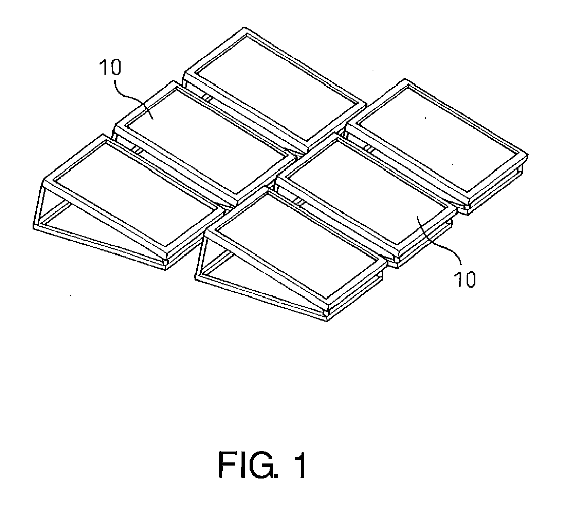

A conventional mechanism of collecting solar power is illustrated in FIG. 1. Solar power is collected by flatly arranged solar panels 10 to be converted into another type of energy. However, solar power is hard to be effectively collected if the solar panels 10 can not correspond with the sun to move. Furthermore, the flatly arranged solar panels 10 must occupy a vast area. Thus the conventional arrangement can not be used in a limited space.

### Summary of the Invention

An object of the invention is to improve efficiency of collecting solar power in a limited space.

To accomplish the above object, the invention includes a solar energy collector and a sunbeam guiding unit. The solar energy collector is formed by a bottom plate and four side walls, all of which are made by solar panels. The sunbeam guiding unit is disposed in or over the solar energy collector for reflecting or refracting the sunbeams to the bottom plate and the side walls.

### Brief Description of the Drawings

FIG. 1 shows a conventional solar collector;
FIG. 2 shows an arrangement of the invention where the sunbeam guiding unit is inside the solar energy collector;
FIG. 3 shows another arrangement of the invention where the sunbeam guiding unit is over the solar energy collector;
FIG. 4 is a side view of FIG. 3; and
FIG. 5 shows a side view of still another embodiment.

### Detailed Description of the Invention

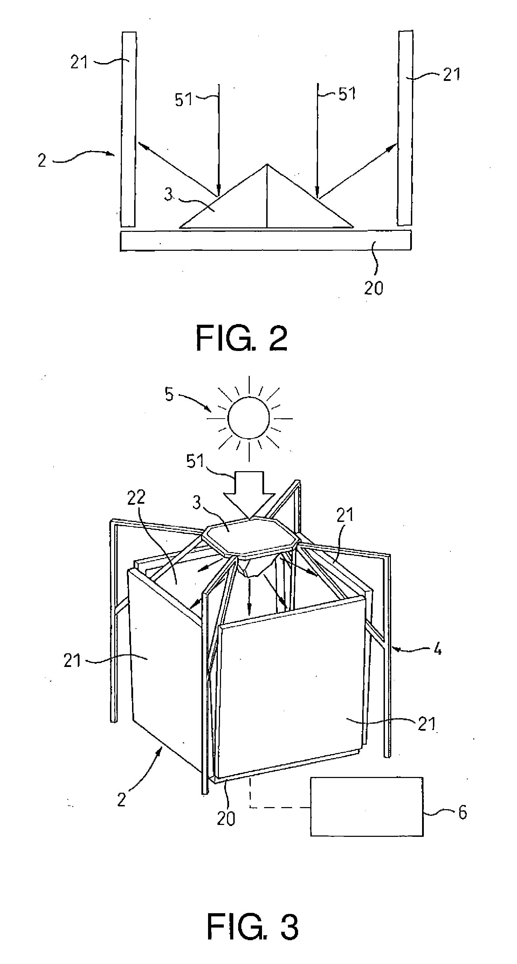

Referring to FIG. 2, the solar energy receiving device of the invention includes a solar energy collector 2 and a sunbeam guiding unit 3.

The solar energy collector 2 is a hollow cuboid formed by a bottom plate 20 and a plurality of side walls 21, all of which are made by solar panels. The solar energy collector 2 absorbs solar energy by sunbeams 51 and outputs power to an external unit 6 (shown in FIG. 3).

The sunbeam guiding unit 3 is disposed in a hollow portion 22 of the solar energy collector 2 on the bottom plate 20 for reflecting the incident sunbeams 51 to the side walls 21. Thus, the sunbeam guiding unit 3 may be a reflecting mirror set.

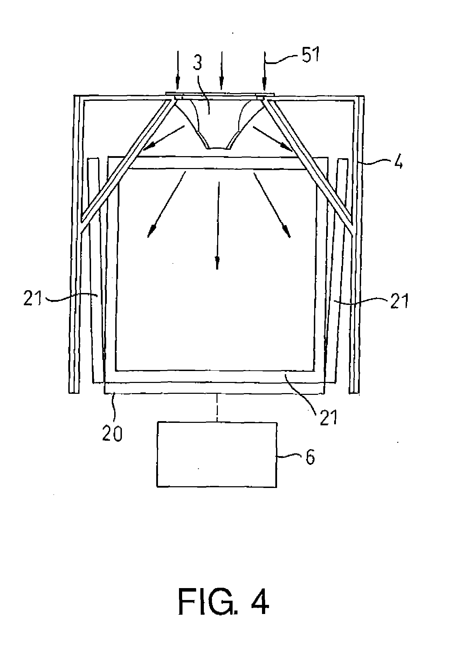

Referring to FIGs. 3 and 4, the sunbeam guiding unit 3 also can be disposed over the solar energy collector 2. The sunbeam guiding unit 3 is supported by a frame 4. The overhead sunbeam guiding unit 3 reflects and/or refracts the incident sunbeams 51 to the bottom plate 20 and side walls 21 of the solar energy collector 2. In this embodiment, the sunbeam guiding unit 3 may be a 5complex prism.

In comparison with prior art, the invention increases the efficiency of absorbing solar energy within a limited space by means of the three-dimensional solar energy collector 2. Also, the invention enhances the efficiency of receiving sunbeams by the sunbeam guiding unit 3.

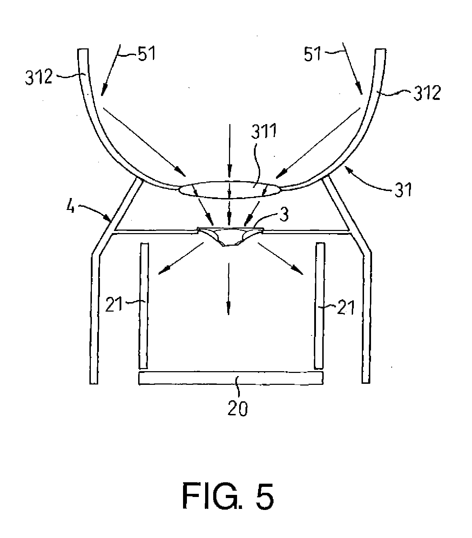

FIG. 5 illustrates another preferred embodiment. The frame 4 supports an assistant sunbeam guiding unit 31. The assistant sunbeam guiding unit 31 is arranged over the sunbeam guiding unit 3 by supporting of the frame 4. The assistant sunbeam guiding unit 31 includes a concentration lens 311 and a collection mirror 312 extending around the concentration lens 311. The concentration lens 311 is over the sunbeam guiding unit 3. The incident sunbeams 51 are reflected by the collection mirror 312 to the concentration lens 311 and sunbeam guiding unit 3. This can further improve the efficiency of sunbeam receiving of the solar energy collector 2.

It will be appreciated by persons skilled in the art that the above embodiments have been described by way of example only and not in any limitative sense, and that various alterations and modifications are possible without departure from the scope of the invention as defined by the appended claims.

## Claims

1. A solar energy receiving device comprising:
a solar energy collector (2) formed by a bottom plate (20) and a plurality of side walls (21), all of which are made by solar panels; and
a sunbeam guiding unit (3) disposed on the bottom plate (20) of the solar energy collector (2) for reflecting incident sunbeams to the side walls (21).

2. The solar energy receiving device of claim 1, wherein the sunbeam guiding unit (3) is a reflecting mirror set.

3. A solar energy receiving device comprising:
a solar energy collector (2) formed by a bottom plate (20) and a plurality of side walls (21) , all of which are made by solar panels; and
a sunbeam guiding unit (3) disposed over the solar energy collector (2) and supported by a frame (4) for reflecting and refracting incident sunbeams to the side walls (21) and the bottom plate (20).

4. The solar energy receiving device of claim 3, wherein the sunbeam guiding unit (3) is a complex prism.

5. The solar energy receiving device of claim 3, wherein the frame (4) supports an assistant sunbeam guiding unit (31) over the sunbeam guiding unit (3), the assistant sunbeam guiding unit (31) includes a concentration lens (311) and a collection mirror (312) extending around the concentration lens (311), thereby incident sunbeams are reflected by the collection mirror (312) to the concentration lens (311) and the sunbeam guiding unit (3).

6. The solar energy receiving device of claim 4, wherein the frame (4) supports an assistant sunbeam guiding unit (31) over the sunbeam guiding unit (3), the assistant sunbeam guiding unit (31) includes a concentration lens (311) and a collection mirror (312) extending around the concentration lens (311), thereby incident sunbeams are reflected by the collection mirror (312) to the concentration lens (311) and the sunbeam guiding unit (3).
